(19)

Europäisches
Patentamt
European
Patent Office
Office européen
des brevets

(11)  **EP 2 278 853 A1**

(12)  **EUROPEAN PATENT APPLICATION**
published in accordance with Art. 153(4) EPC

(43) Date of publication:
**26.01.2011  Bulletin 2011/04**

(51) Int Cl.:
*H05B 33/02* (2006.01)    *G02B 5/02* (2006.01)
*H01L 51/50* (2006.01)    *H05B 33/10* (2006.01)

(21) Application number: **09725116.9**

(22) Date of filing: **24.03.2009**

(86) International application number:
**PCT/JP2009/055778**

(87) International publication number:
**WO 2009/119558 (01.10.2009 Gazette 2009/40)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **28.03.2008  JP 2008086246**

(71) Applicant: **Sumitomo Chemical Company, Limited Tokyo 104-8260 (JP)**

(72) Inventor: **WATANABE, Kazuhito Tsukuba-shi Ibaraki 305-0821 (JP)**

(74) Representative: **Duckworth, Timothy John J.A. Kemp & Co. 14 South Square Gray's Inn London WC1R 5JJ (GB)**

(54)  **ORGANIC ELECTROLUMINESCENT DEVICE AND METHOD FOR MANUFACTURING THE SAME**

(57)    Disclosed is an organic electroluminescent device comprising a light-emitting layer containing an organic matter, and a film so arranged as to face the light-emitting layer and located in the front surface portion of the device. The film has projections and recesses in a surface opposite to the light-emitting layer-side surface, while having a haze value of not less than 70% and a total light transmittance of not less than 80%.

# FIG.1

Printed by Jouve, 75001 PARIS (FR)

**Description**

TECHNICAL FIELD

The present invention relates to an organic electroluminescent device and a method for manufacturing the same.

BACKGROUND ART

An organic electroluminescent (EL) device is configured from a pair of electrodes and a light-emitting layer including an organic material provided between the electrodes. The light-emitting layer emits light by applying a voltage between the electrodes. The light from the light-emitting layer is extracted from at least one side of the pair of electrodes. Much of the light produced from the light-emitting layer is, for example, absorbed in the organic EL device or is completely reflected. Therefore, the light extraction efficiency of an organic EL device is small. Much of the light produced from the light-emitting layer is not externally extracted, and thus is not utilized effectively.

Accordingly, in the conventional art, proposals have been made to improve the light extraction efficiency by providing a light-scattering layer between a transparent substrate on which the organic EL device is provided and the electrodes of the organic EL device to suppress the total reflection of light (e.g., see PATENT DOCUMENT 1).

PATENT DOCUMENT 1: JP 2007-035550 A

DISCLOSURE OF THE INVENTION

PROBLEMS TO BE SOLVED BY THE INVENTION

In a conventional organic EL device, the light extraction efficiency is not always sufficient. Therefore, there is a need for further improvement in the light extraction efficiency.

Accordingly, it is an object of the present invention to provide an organic EL device having a high light extraction efficiency and a method for manufacturing the same.

MEANS FOR SOLVING THE PROBLEMS

The present invention is an organic electroluminescent device including a light-emitting layer which includes an organic material and a film which is arranged facing the light-emitting layer and which is located on a surface portion, wherein the film has an uneven surface on the opposite side to the light-emitting layer side, a haze value of 70% or more and a total light transmittance of 80% or more.

Further, the present invention is the above-described organic electroluminescent device, wherein a surface of the film located opposite to the light-emitting layer is provided with a plurality of concavities and is unevenly formed.

Further, the present invention is a lighting device comprising the above-described organic electroluminescent device.

Further, the present invention is a method for manufacturing a film which is platy in shape and uneven on one surface and has a haze value of 70% or more and a total light transmittance of 80% or more, the method comprising: an application step comprising applying a solution comprising a material for constituting the film to a surface of a base on which the film is to be formed so that the film may have a thickness in a range of 100 $\mu$m to 200 $\mu$m; and a film formation step comprising forming a film by holding the solution applied to the surface of the base at a humidity in a range of 80% to 90%, and then drying.

Further, the present invention is a method for manufacturing an organic electroluminescent device comprising a light-emitting layer which includes an organic material and a film which is arranged facing the light-emitting layer and which is located on a surface portion, the method comprising the steps of: forming a light-emitting layer which comprises an organic material; and providing on the surface portion a film produced by the above-described film production method.

ADVANTAGES OF THE INVENTION

According to the present invention, an organic EL device having a high light extraction efficiency can be realized.

Further, according to the present invention, a film having intended optical properties can be easily manufactured by a simple control.

In addition, according to the present invention, since a film having intended optical properties can be easily produced by a simple control, an organic EL device having a high light extraction efficiency can be easily manufactured.

BRIEF DESCRIPTION OF THE DRAWINGS

Fig. 1 is a front view illustrating an organic EL device 1 according to an embodiment of the present invention;
Fig. 2 is a diagram schematically illustrating a cross-section of a film 3 produced in Example 1;
Fig. 3 is a diagram schematically illustrating a cross-section of a film 3 used in Example 2; and
Fig. 4 is a diagram schematically illustrating a cross-section of a film 3 produced in Comparative Example 1.

BEST MODE FOR CARRYING OUT THE INVENTION

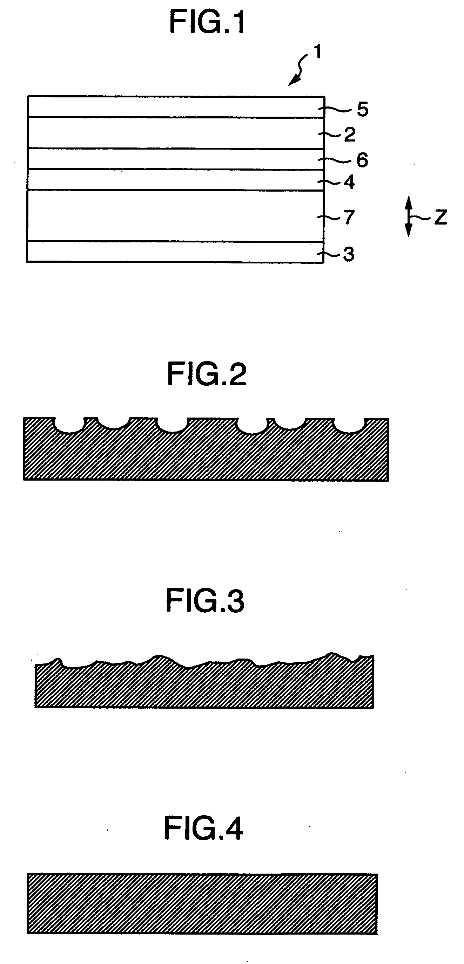

Fig. 1 is a front view illustrating an organic EL device 1 according to an embodiment of the present invention. The organic EL device 1 according to the present embodiment includes a light-emitting layer 2 including an organic material, and a film 3 which is arranged facing the light-emitting layer 2 and located on a surface portion of the organic EL device 1. One surface of the film 3 perpendicular to the thickness direction of the film 3 (hereinafter, sometimes referred to as first surface) is arranged facing the light-emitting layer 2, and the other surface on the opposite side to the light-emitting layer 2 (hereinafter, sometimes referred to as second surface) is formed in an uneven shape. Further, the film 3 has a haze value of 70 or more, and a total light transmittance of 80% or more.

The organic EL device 1 is configured from a pair of electrodes consisting of at least an anode 4 and a cathode 5, and a light-emitting layer 2 which is provided between the pair of electrodes. Between the anode 4 and the light-emitting layer 2, and/or between the light-emitting layer 2 and the cathode 5, one or a plurality of layers may be provided. In the organic EL device 1 according to the present embodiment, a hole injection layer 6 is provided between the anode 4 and the light-emitting layer 2. The organic EL device 1 according to the present embodiment is configured from the anode 4, the hole injection layer 6, the light-emitting layer 2, and the cathode 5 laminated in that order on one surface in the thickness direction of a substrate 7. In addition, this organic EL device 1 is formed with the film 3 laminated on the other surface in the thickness direction of the substrate 7. Below, the thickness direction of the substrate is also referred to as laminated direction Z.

The organic EL device 1 according to the present embodiment forms a so-called bottom emission type device, in which light from the light-emitting layer 2 is extracted from the substrate 7 side. Specifically, light from the light-emitting layer 2 passes through the substrate 7 and the film 3, and exits from the unevenly-formed surface of the film 3. Therefore, it is preferred to use a transparent substrate for the substrate 7. Further, it is also preferred to use a substrate 7 which does not change during the step of forming the organic EL device 1. A rigid substrate or a flexible substrate may be used. Preferred examples which may be used include glass, plastic, a polymer film, a silicon substrate, and a laminated substrate of these. The substrate 7 in the present embodiment is formed from glass.

The anode 4 is formed laminated on the one surface in the laminated direction Z of the substrate 7. The anode 4 is realized by a thin film which is conductive and also is transparent to the light from the light-emitting layer 2. A thin film formed from a metal oxide, metal sulfide, metal and the like having a high electrical conductivity may be used for the anode 4. Of these thin films, it is preferred to use a thin film having a high light transmittance. The thin film is appropriately selected based on the configuration of the organic layers provided between the anode 4 and the cathode 5. More specifically, a thin film formed from indium oxide, zinc oxide, tin oxide, indium tin oxide (ITO), indium zinc oxide (IZO), gold, platinum, silver, copper and the like is used. Of these, it is preferred to use a thin film formed from ITO, IZO, or tin oxide. In the present embodiment, a thin film formed from ITO is used.

Examples of methods for producing the anode 4 include vacuum vapor deposition, sputtering, ion plating, and plating. Further, as the anode 4, a transparent conductive film including an organic material, such as polyaniline, polyaniline derivatives, polythiophene, and polythiophene derivatives, may be used.

The hole injection layer 6 is formed laminated on the one surface in the laminated direction Z of the anode 7. The hole injection layer 6 is a layer having a function for improving the hole injection efficiency from the anode 7. Examples of the hole injection material used for the hole injection layer 6 include a phenylamine compound, a starburst-type amine compound, a phthalocyanine compound, oxides such as vanadium oxide, molybdenum oxide, ruthenium oxide, and aluminum oxide, amorphous carbon, polyaniline, and polythiophene derivatives.

The hole injection layer 6 is formed by, for example, applying a coating solution including the hole injection material to the anode 4 to form a liquid film, and then drying this liquid film. The hole injection layer 6 can be formed by simply applying the solution and then drying to remove the solvent. Further, the below-described hole transport layer and the light-emitting layer can also be formed by applying the same method as for the hole injection layer 6. Therefore, a method in which a coating solution is applied is very preferable in terms of manufacturing. Examples of such a method in which a coating solution is applied include coating methods such as spin coating, casting, micro gravure coating, gravure coating, bar coating, roll coating, wire bar coating, dip coating, spray coating, screen printing, flexographic printing, offset printing, and inkjet printing. The hole injection layer 6 can also be formed by the same above-described method of forming the film from a solution even when an emulsion-like dispersion in which the hole injection material is dispersed in water or alcohol is used as the coating solution.

Although the solvent or dispersion medium used in the coating solution including the hole injection material is not especially limited, preferably the solvent or dispersion medium can dissolve or uniformly disperse the other materials forming the coating solution. Examples of the solvent used in the coating solution including the hole injection material include chlorinated solvents such as chloroform, methylene chloride, and dichloroethane, ether solvents such as tetrahydrofuran, aromatic hydrocarbon solvents such as toluene, xylene, tetralin, anisole, n-hexylbenzene, and cyclohexylbenzene, aliphatic hydrocarbon solvents such as decalin, and bicyclohexyl, ketone solvents such as acetone, methyl ethyl ketone, and 2-heptanone, ester solvents such as ethyl acetate, butyl acetate, ethyl cellosolve acetate, and propylene glycol monomethyl ether acetate, and water.

The optimum thickness of the hole injection layer 6 depends on the used material, and is selected so that the drive voltage and the light emission efficiency are appropriate values. Further, the hole injection layer 6 needs to be thick enough so that pin holes do not form. However, the thickness is preferably not too thick, otherwise the drive voltage of the device increases. Therefore, the hole injection layer 6 has a thickness of, for example, from 1 nm to 1 $\mu$m, preferably 2 nm to 500 nm, and more preferably 5 nm to 200 nm.

The light-emitting layer 2 is formed laminated on the one surface in the laminated direction Z of the hole injection layer 6. The light-emitting layer 2 is, usually, mainly formed from an organic material which emits fluorescence and/or phosphorescence, or a mixture of such organic material and a dopant. The organic material may be a low-molecular weight compound or a polymeric compound. The dopant is added to the organic material for the purpose of, for example, improving the light emission efficiency and changing the emission wavelength. Examples of the light-emitting material constituting the light-emitting layer 2 include a pigment material, a metal complex material, and a polymeric material, as well as a dopant material added to these. Specific examples include the following.

<Pigment material>

Examples of the pigment material include a cyclopentamine derivative, a tetraphenyl butadiene derivative compound, a triphenylamine derivative, an oxadiazole derivative, a pyrazoloquinoline derivative, a distyrylbenzene derivative, a distyrylarylene derivative, a pyrrole derivative, a thiophene ring compound, a pyridine ring compound, a perinone derivative, a perylene derivative, an oligothiophene derivative, a triphenylamine derivative, an oxadiazole dimer, and a pyrazoline dimer.

<Metal complex material>

Examples of the metal complex material include a metal complex having, for a central metal, a rare earth metal such as Tb, Eu, and Dy, or Al, Zn, Be and the like, and for a ligand, an oxadiazole, a thiadiazole, a phenylpyridine, a phenylbenzimidazole, a quinoline structure and the like. Further examples include metal complexes which emit light from a triplet excited state, such as indium complexes and platinum complexes, and metal complexes such as an aluminum quinolinol complex, a benzoquinolinol beryllium complex, a benzoxazolyl zinc complex, a benzothiazole zinc complex, an azomethyl zinc complex, a porphyrin zinc complex, and europium complexes.

<Polymeric material>

Examples of the polymeric material include poly(p-phenylenevinylene) derivatives, polythiophene derivatives, poly-p-phenylene derivatives, polysilane derivatives, polyacetylene derivatives, polyfluorene derivatives, polyvinylcarbazole derivatives, and polymers prepared by polymerizing the above-described pigment material or metal complex material.

Of these light-emitting materials, examples of blue emitting materials include distyrylarylene derivatives, oxadiazole derivatives and polymers thereof, polyvinylcarbazole derivatives, poly(p-phenylene) derivatives, and polyfluorene derivatives. Of these, polyvinylcarbazole derivatives, poly(p-phenylene) derivatives, polyfluorene derivatives, and the like, which are polymer materials, are preferred.

Examples of green emitting materials include quinacridone derivatives, coumarin derivatives, and polymers thereof, poly-p-phenylenevinylene derivatives and polyfluorene derivatives. Of these, poly(p-phenylenevinylene) derivatives, polyfluorene derivatives, and the like, which are polymer materials, are preferred.

Examples of red emitting materials include coumarin derivatives, thiophene ring compounds, and polymers thereof, poly(p-phenylenevinylene) derivatives, polythiophene derivatives, and polyfluorene derivatives. Of these, poly(p-phenylenevinylene) derivatives, polythiophene derivatives, polyfluorene derivatives, and the like, which are polymer materials, are preferred.

<Dopant material>

Examples of dopants include perylene derivatives, coumarin derivatives, rubrene derivatives, quinacridone derivatives, squalium derivatives, porphyrin derivatives, styryl dyes, tetracene derivatives, pyrazolone derivatives, decacyclene, and phenoxazone.

The thickness of the light-emitting layer 2 is usually about 2 nm to 200 nm. Examples of methods which can be used for forming the light-emitting layer 2 including an organic material include applying a solution including the light-emitting material to one surface in the laminated direction Z of the hole injection layer 6, vacuum vapor deposition, a transfer method and the like.

Examples of a method in which a solution including the light-emitting material is applied include coating methods such as spin coating, casting, micro gravure coating, gravure coating, bar coating, roll coating, wire bar coating, dip coating, slit coating, capillary coating, spray coating, and nozzle coating, as well as other coating methods such as gravure printing, screen printing, flexographic printing, offset printing, reverse printing, and inkjet printing. Of these, from the standpoint that pattern formation and separation into multiple colors are easy, coating methods such as gravure printing, screen printing, flexographic printing, offset printing, reverse printing, and inkjet printing are preferred. Specific examples of the solvent used in forming a film from a solution include the same solvents as those for dissolving the hole injection material when forming the hole injection layer 6 from the above-described solution. Further, when a sublimable low molecular weight compound is used as the light-emitting material, vacuum vapor deposition can be used. Moreover, a method in which the light-emitting layer 2 is formed only on a desired region can also be used, by using transfer or thermal transfer performed with a laser.

The cathode 5 is formed laminated on one surface in the laminated direction Z of the light-emitting layer 2. It is preferred that the material used for the cathode 5 has a small work function and allows easy electron injection into the light-emitting layer 2. Examples of the material used for the cathode 5 include, for example, metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium, or an alloy of 2 or more of these metals, or an alloy of one or more of these metals and one or more of gold, silver, platinum, copper, manganese, titanium, cobalt, nickel, tungsten, and tin, or graphite or a graphite intercalation compound. Examples of alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

The cathode 5 may be a monolayer structure or a laminated structure of two or more layers. Examples of laminated structures include a laminated structure formed from the above-described metals, metal oxides, fluorides, and alloys thereof and a metal such as aluminum, silver, chromium and the like.

The thickness of the cathode 5 can be appropriately selected in consideration of electrical conductivity and durability. The thickness is, for example, 10 nm to 10 $\mu$m, preferably 20 nm to 1 $\mu$m, and more preferably 50 nm to 500 nm. Methods for producing the cathode 5 include vacuum vapor deposition, sputtering, or laminating by thermal compression of a metal thin film.

The film 3 has one surface in the thickness direction having a flat shape, and the other surface in the thickness direction having an uneven shape. This film 3 is formed with the flat surface bonded to the other surface in the laminated direction Z of the substrate 7. The film 3 is bonded to the substrate 7 using a bonding agent, such as a thermosetting resin, a photocurable resin, an adhesive, and a pressure-sensitive adhesive. When using a thermosetting resin, the film 3 is adhered to the substrate 7 by bonding the film 3 to the substrate 7 and then heating at a predetermined temperature. When using a photocurable resin, the film 3 is adhered to the substrate 7 by bonding the film 3 to the substrate 7 and then irradiating UV-rays, for example, on the film 3. When directly forming the film 3 on the substrate 7 or providing in advance a bonding agent on the film 3, or the like, the above-described bonding agent does not have to be used.

If an air layer is formed between the film 3 and the substrate 7, reflection occurs at the interface of this air layer. Therefore, it is preferred to bond the film 3 to the substrate 7 so that an air layer is not formed between the film 3 and the substrate 7. It is preferred that the difference between the maximum refractive index and the minimum refractive index among the refractive index of the film 3, the refractive index of the bonding agent, and the refractive index of the layer which is bonded to the film 3 (in the present embodiment, the substrate 7) is small, as this allows reflection at the bonding face to be controlled. Specifically, it is preferred that this difference is 0.2 or less, and more preferably 0.1 or less.

The film 3 according to the present embodiment is formed so that the other surface on the opposite side to the light-emitting layer 2 is formed in an uneven shape, with a haze value of 70% or more, and a total light transmittance of 80% or more. If the haze value is less than 70%, a sufficient light scattering effect may not be obtained. If the total light transmittance is less than 80%, sufficient light may not be extracted, so that when such a film is used as the organic EL device 1, a sufficient light extraction efficiency may not be realized. However, by using a film 3 having a haze value of 70% or more and a total light transmittance of 80% or more, an organic EL device 1 having a high light extraction efficiency can be realized. The haze value is expressed by the following expression.

$$\text{Haze value (cloudiness value)} = (\text{diffuse transmission (\%)/total light}$$

$$\text{transmittance (\%))} \times 100 \ (\%)$$

The haze value can be measured by the method described in JIS K 7136 "Method for determining the haze of plastic - transparent materials". Further, the total light transmittance can be measured by the method described in JIS K 7361-1 "Testing method for total light transmittance of plastic - transparent materials".

If the size of the perpendicular direction in the laminated direction Z of the respective concavities or convexities formed on the surface of the film 3 is too large, the luminance at the surface of the film 3 becomes uneven. If this size is too small, the production costs of the film 3 increase. Therefore, this size is preferably 0.5 μm to 20 μm, and more preferably 1 μm to 2 μm. Further, the height in the laminated direction Z of the respective concavities or convexities is determined based on the size of the perpendicular direction in the laminated direction Z of the respective concavities or convexities, and the period in which the uneven shapes are formed. Usually, it is preferred that this height is equal to or less than the size of the perpendicular direction in the laminated direction Z of the respective concavities or convexities or equal to or less than the period in which the uneven shapes are formed. Specifically, this height is 0.25 μm to 10 μm, and preferably 0.5 μm to 1.0 μm.

Although the shape of the concavities or convexities is not especially limited, it is preferred that they have a curved face. For example, a hemispherical shape is preferred. It is preferred that the concavities or convexities are regularly arranged. For example, it is preferred that the concavities or convexities are arranged like the grid on a Japanese "Go" board. Further, within the second surface of the film 3, it is preferred that the surface area of the region on which the concavities and the convexities are formed is 60% or more of the surface area of the second surface of the film 3.

The material constituting the film 3 may be a transparently-formed material. For example, a polymeric material or glass may be used. Examples of polymeric materials constituting the film 3 include polyarylate, polycarbonate, polycycloolefin, polyethylene naphthalate, polyethylene sulfonic acid, and polyethylene terephthalate. Further, the film 3 may be formed from a laminated structure of, for example, a support substrate formed from an above-described polymeric material, glass or the like and a thin film which is formed on the surface on this support and whose surface on the opposite side to the surface in contact with the support substrate is unevenly formed. The thickness of the film 3 is not especially limited. However, if this thickness is too thin, the film 3 becomes difficult to handle, while if the thickness is too thick, the total light transmittance decreases. Therefore, a thickness of 20 μm to 1,000 μm is preferable.

The method for manufacturing the film 3 will now be described.

The film 3 according to the present embodiment can be obtained by forming uneven shapes on the surface of a film. The size of the uneven shapes formed on the surface is about the same as, or larger than, the wavelength of light, and is 0.1 μm to 100 μm.

For a film 3 formed from an inorganic material such as glass, the concavities and convexities can be formed by pre-forming a protective film in which a photoresist was cured in regions where the uneven shapes are not formed, and carrying out chemical etching or gas-phase etching. Further, for a film 3 formed from a polymeric material, the concavities and convexities can be formed by methods such as: transferring concavities and convexities onto a metal plate by pressing a metal plate having an uneven surface on a heated film; drawing a polymer sheet or a film using a roll having an uneven surface; extruding and molding a polymer sheet from a slit having an uneven shape; forming a film by dropping a solution or a dispersion including a polymeric material onto a base having an uneven surface (hereinafter, sometimes referred to as casting); forming a film from a monomer, then selectively photopolymerizing a part of the film, and removing the unpolymerized portions; and casting a polymer solution onto a base under high humidity conditions to transfer the droplet structure onto the surface.

Among these methods, for a polymeric material, from the perspective of ease of production, it is preferred to use the method of casting a polymer solution onto a base under high humidity conditions to transfer the droplet structure onto the surface. This method is a known structure production method applying a dissipation process, which is one kind of self organization (e.g., see G Widawski, M. Rawiso, B. Francois, Nature, p. 369 to p. 387 (1994)).

First, a solution for the film 3 is prepared by dissolving the above-described polymeric material constituting the film 3 in a solvent. Examples of this solvent include dichloromethane and chloroform. It is preferred that this solution for the film 3 has a high viscosity. Further, as the solution for the film 3, a solution having a high concentration of the polymeric material that will form the film 3 is preferred. It is preferred that the concentration of the polymeric material that will form the film 3 is 10 wt.% or more. To improve the size of the uneven shapes and to improve the uniformity of the shapes, the solution for the film 3 may be used by adding a small amount of a surfactant, such as a nonionic surfactant, to the solution for the film 3.

Next, a coating step is performed for applying the solution including the material constituting the film 3 onto a first surface of the base, on which the film 3 will be formed on the surface. More specifically, the above-prepared solution for the film 3 is cast onto the first surface of the base under high humidity conditions, to form a liquid film consisting of the solution for the film 3. Examples of the base include the above-described support substrate formed from an above-described polymeric material, glass or the like.

Next, a film-forming step is performed for forming a film by holding the solution applied on the first surface of the base at a humidity in the range of 80% to 90%, and then drying. When the liquid film is left under high humidity, water vapor in the atmosphere liquefies, whereby a plurality of liquid droplets are formed on the surface of the liquid film. The liquid droplets are roughly spherical, and are discretely formed on the surface of the liquid film. Over time the radius of the liquid droplets formed on the surface of the liquid film increases due to further water vapor liquefaction, so that roughly half of each liquid droplet sinks into the liquid film from its own weight. Moreover, since the solvent in the liquid film evaporates over time, the shape of the liquid droplets is transferred onto the film 3 during the drying. The thus-formed film 3 is formed in an uneven shape with a plurality of concavities on its surface. More specifically, a plurality of hemispherical depressions having a radius of 1 $\mu$m to 100 $\mu$m are formed on the surface. The film may also be formed by forming the hemispherical depressions by holding at a humidity in the range of 80% to 90%, then forming the liquid film and drying under an atmosphere having a lower humidity. Alternatively, the film may be formed by holding for a prolonged period in the range of 80% to 90% and then drying.

In the above-described method for producing the film 3, the haze value of the produced film 3 can be controlled by controlling the coating with the solution for the film 3 so that the film 3 thickness is a predetermined value, and by regulating the humidity when drying the liquid film. More specifically, a film 3 exhibiting a predetermined haze value of 70 or more can be formed by controlling the thickness of the liquid film at the start of drying so that the thickness of a film 3 formed by undergoing the film-formation step will be in the range of 100 $\mu$m to 200 $\mu$m, and by controlling the humidity so that the humidity is a predetermined value in the range of 80% to 90%. The reason why the haze value of the film 3 can be controlled by controlling the humidity and the film thickness is that if the humidity and the film thickness are changed, the time it takes for the surface of the liquid film to dry changes depending on the concentration and the like in the solution of the polymeric material which will form the film 3, so that the size of the uneven shapes and the density of the formed concavities changes. Further, it is also thought that the humidity has a large influence on the building of the formed concavity structures, such as improving the regularity of the arrangement of the concavities. The thickness of the produced film 3 can be controlled by regulating the thickness of the liquid film when starting the drying. In addition, since the time it takes for the surface of the liquid film to dry depends on the rate of evaporation of the solvent, the boiling point of the solvent and the like, the haze value of the film 3 can be controlled by changing the used solvent. Based on this method, a film 3 having a large surface area which exhibits intended optical properties can be produced easily and cheaply. Further, the film 3 can also be directly formed on the substrate 2 by casting a solution for the film 3 on the surface of the substrate 2.

In the above-described organic EL device 1 according to the present embodiment, the film 3 is arranged on a surface portion of the organic EL device 1. This film 3 is formed so that the surface on the opposite side to the light-emitting layer 2 side is formed in an uneven shape, so that at least a portion of the surface of the organic EL device 1 is formed in an uneven shape. Some of the light produced in the light-emitting layer 2 is incident on the film, and is diffracted at the surface formed in an uneven shape. For example, this light exits into an atmosphere such as the air. If, for example, the surface on the opposite side to the light-emitting layer 2 side of the film 3 is a smooth plane, most of the light produced from the active layer 2 by total reflection occurring at the surface of the organic EL device is not extracted. However, by forming the surface from which light is extracted in an uneven shape, total reflection can be suppressed by utilizing a diffraction effect, so that the light can be efficiently extracted. Especially, because a film having a haze value of 70% or more and a total light transmittance of 80% or more is provided, the light extraction efficiency can be improved, so that an organic EL device 1 having a high light extraction efficiency can be realized.

According to the organic EL device 1 of the present embodiment, since the plurality of concavities are provided on the other surface of the film 3, which is the opposite side to the light-emitting layer 2 side, the concavities exhibit a function similar to that of a concave lens. Providing such a film 3 allows the angle of radiation of the light radiated from the organic EL device 1 to be broadened.

Further, the film 3 used in the organic EL device 1 according to the present embodiment is formed by a coating step for applying a solution including a material for forming the film 3 to a first surface of a base, and a film-forming step for forming a film by drying the applied liquid film. Especially, a film having a surface formed in an uneven shape and having a haze value of 70% or more and a total light transmittance of 80% or more can be manufactured by applying the solution including the material for forming the film 3 so that the thickness of the film after the film-forming step is 100 $\mu$m to 200 $\mu$m, and drying the applied solution at a humidity in the range of 80% to 90%. Consequently, a film having intended optical properties can be easily manufactured by a simple control of regulating the solution application amount and the humidity, for example.

Further, according to the organic EL device 1 of the present embodiment, as described above, since the film 3 used in the organic EL device 1 can be easily produced by a simple control, an organic EL device having a high light extraction efficiency can be easily manufactured.

In the above-described organic EL device 1 according to the present embodiment, although the film 3 was bonded to the substrate 7, the location where the film 3 is provided is not limited to this. For example, for a so-called top-emission type organic EL device, in which the light is extracted from the opposite side (cathode 5 side) to the substrate 7, the film 3 may be bonded to the surface on the opposite side to the light-emitting layer 2 of the cathode 5. Moreover, in a top-emission type organic EL device in which the cathode is formed on the surface of the substrate, and the cathode, the light-emitting layer, and the anode are arranged in that order on the substrate, the film may be bonded to the surface on the opposite side to the light-emitting layer of the anode.

In the above-described organic EL device 1 according to the present embodiment, the light-emitting layer 2 and the hole injection layer 6 were arranged between the anode 4 and the cathode 5. However, the organic EL device applied by the present invention may also have at least the light-emitting layer 2 arranged between the anode 4 and the cathode 5. The layer structure of the present embodiment is not limited. Further examples of the structure of the organic EL device which can be applied by the present invention will now be described below.

As described above, one or a plurality of layers may be provided between the anode and the light-emitting layer and/or between the light-emitting layer and the cathode. Between the anode and the light-emitting layer, layers such as an electron injection layer, an electron transport layer, and a hole blocking layer are provided. When two or more layers are provided between the cathode and the light-emitting layer, among the plurality of layers, the layer in contact with the cathode is called an electron injection layer, and layers other than this electron injection layer are called an electron transport layer.

The electron injection layer has a function for improving the electron injection efficiency from the cathode. The electron transport layers have a function for improving electron injection from the electron injection layer or from an electron transport layer which is closer to the cathode. If the electron injection layer or the electron transport layers have a function for blocking hole transportation, these layers may be referred to as a hole blocking layer. The fact that a layer has a function for blocking hole transportation can be confirmed by, for example, producing a device through which only a hole current flows, and confirming whether there is a blocking effect due to a decrease in the current value.

Examples of layers that can be provided between the anode and the light-emitting layer include a hole injection layer, a hole transport layer, and an electron blocking layer. When two or more layers are provided between the anode and the light-emitting layer, among the plurality of layers, the layer in contact with the anode is called a hole injection layer, and layers other than this hole injection layer are called a hole transport layer.

The hole injection layer has a function for improving the hole injection efficiency from the anode. The hole transport layers have a function for improving hole injection from the hole injection layer or from a hole transport layer which is closer to the anode. If the hole injection layer or the hole transport layers have a function for blocking electron transportation, these layers may be referred to as an electron blocking layer. The fact that a layer has a function for blocking electron transportation can be confirmed by, for example, producing a device through which only an electron current flows, and confirming whether there is a blocking effect due to a decrease in the current value. The electron transport layers and the hole transport layers may be collectively referred to as charge transport layers.

Examples of specific structures of the respective layers which are arranged between the anode and the cathode are illustrated below.

a) Anode/light-emitting layer/cathode
b) Anode/hole transport layer/light-emitting layer/cathode
c) Anode/light-emitting layer/electron transport layer/cathode
d) Anode/hole transport layer/light-emitting layer/electron transport layer/cathode
e) Anode/hole injection layer/light-emitting layer/cathode
f) Anode/light-emitting layer/electron injection layer/cathode
g) Anode/hole injection layer/light-emitting layer/electron injection layer/cathode
h) Anode/hole injection layer/hole transport layer/light-emitting layer/cathode
i) Anode/hole transport layer/light-emitting layer/electron injection layer/cathode
j) Anode/hole injection layer/hole transport layer/light-emitting layer/electron injection layer/cathode
k) Anode/hole injection layer/light-emitting layer/electron transport layer/cathode
l) Anode/light-emitting layer/electron transport layer/electron injection layer/cathode
m) Anode/hole injection layer/light-emitting layer/electron transport layer/electron injection layer/cathode
n) Anode/hole injection layer/hole transport layer/light-emitting layer/electron transport layer/cathode
o) Anode/hole transport layer/light-emitting layer/electron transport layer/electron injection layer/cathode
p) Anode/hole injection layer/hole transport layer/light-emitting layer/electron transport layer/electron injection layer/cathode

(here, the symbol "/" represents the fact that the two layers on either side of the "/" are laminated adjacent to each other. Hereinafter the same.)

Further, a plurality of light-emitting layers, the hole transport layers, and the electron transport layers may be respectively and independently laminated to form the structure.

To improve adhesion with the electrodes and to improve the charge injection efficiency from the electrodes, an insulating layer having a thickness of 2 nm or less may be provided adjacent to the electrodes. Further, to improve adhesion at the interfaces and to prevent mixing, and the like, a thin buffer layer may be inserted between adjacent layers, such as the charge transport layer and the light-emitting layer. The laminated order of the laminated layers, the number of layers, the thickness of each layer and the like can be appropriately selected based on the light emission efficiency and the device life.

The structure and production method of the respective layers will now be described in more detail. However, since the anode, the cathode, the light-emitting layer, and the hole injection layer were described above for the organic EL device 1 according to the above-described embodiment, overlapping descriptions will be omitted here.

<Hole transport layer>

Examples of the hole transport material used for the hole transport layer include polyvinylcarbazole or derivatives thereof, polysilane or derivatives thereof, polysiloxane derivatives having an aromatic amine in a side chain or in the main chain, pyrazoline derivatives, arylamine derivatives, stilbene derivatives, triphenyldiamine derivatives, polyaniline or derivatives thereof, polythiophene or derivatives thereof, polyarylamine or derivatives thereof, polypyrrole or derivatives thereof, poly(p-phenylenevinylene) or derivatives thereof, and poly(2,5-thienylenevinylene) or derivatives thereof.

Among these, as the hole transport material used for the hole transport layer, it is preferred to use a polymeric hole transport material, such as polyvinylcarbazole or derivatives thereof, polysilane or derivatives thereof, polysiloxane derivatives having an aromatic amine in a side chain or in the main chain, polyaniline or derivatives thereof, polythiophene or derivatives thereof, polyarylamine or derivatives thereof, poly(p-phenylenevinylene) or derivatives thereof or poly(2,5-thienylenevinylene) or derivatives thereof. Further, it is more preferred to use polyvinylcarbazole or derivatives thereof, polysilane or derivatives thereof, and polysiloxane derivatives having an aromatic amine in a side chain or in the main chain, and the like. When using a low molecular weight hole transport material for the hole transport layer, it is preferred to use such a material by dispersing it in a polymeric binder.

Examples of the method for forming the hole transport layer include forming from a liquid including the above-described hole transport material. For example, when using a polymeric hole transport material for the hole transport layer, the layer can be formed from a solution in which the hole transport material is dissolved in a solvent. When using a low molecular weight hole transport material for the hole transport layer, the layer can be formed from a mixture in which the hole transport material is dissolved in a dispersant such as a polymeric binder.

As the solvent used for forming from a solution, a solvent in which the hole transport material dissolves is used. Examples of the solvent include chlorinated solvents such as chloroform, methylene chloride and dichloroethane, ether solvents such as tetrahydrofuran, aromatic hydrocarbon solvents such as toluene and xylene, ketone solvents such as acetone and methyl ethyl ketone, and ester solvents such as ethyl acetate, butyl acetate and ethyl cellosolve acetate. The method for forming from a mixture is carried out from a similar solution.

Examples of the method used for forming from a solution include spin coating, casting, micro gravure coating, gravure coating, bar coating, roll coating, wire bar coating, dip coating, spray coating, screen printing, flexographic printing, offset printing, inkjet printing and the like.

As the polymeric binder used in forming from a mixture, it is preferred to use a binder that does not excessively inhibit charge transportation, and also preferred to use a binder that does not strongly absorb visible light. Examples of polymeric binders which may be used include polycarbonate, polyacrylate, polymethyl acrylate, polymethyl methacrylate, polystyrene, polyvinyl chloride and polysiloxane. The method for forming from a mixture is carried out in a similar manner.

<Electron transport material>

A known material can be used for the electron transport material constituting the electron transport layer. Examples thereof include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, or metal complexes of 8-hydroxyquinoline or derivatives thereof, polyquinoline or derivatives thereof, polyquinoxaline or derivatives thereof and polyfluorene or derivatives thereof.

Among these, as the electron transport material constituting the electron transport layer, preferable are oxadiazole derivatives, benzoquinone or derivatives thereof, anthraquinone or derivatives thereof, or the metal complexes of 8-hydroxyquinoline or derivatives thereof, polyquinoline or derivatives thereof, polyquinoxaline or derivatives thereof and polyfluorene or derivatives thereof, and more preferable are 2-(4-biphenylyl)-5-(4-t-butylphenyl)-1,3,4-oxadiazole, benzoquinone, anthraquinone, tris(8-quinolinol)aluminum and polyquinoline.

The method for forming the electron transport layer is not particularly limited. For low molecular weight electron transport materials, examples include vacuum vapor deposition from a powder or a method in which the layer is formed from a solution or a molten state. For polymeric electron transport materials, examples include a method in which the layer is formed from a solution or a molten state. When the layer is formed from a solution or a molten state, the polymeric binder may be used simultaneously. Examples of methods for forming the electron transport layer from a solution include the same methods as described above for forming the hole injection layer from a solution.

The optimum thickness of the electron transport layer depends on the used material, and is selected so that the drive voltage and the light emission efficiency are appropriate values. Further, the electron transport layer needs to be thick enough so that pin holes do not form. However, the electron transport layer is preferably not too thick, otherwise the drive voltage of the device increases. Therefore, the electron transport layer has a thickness of, for example, from 1 nm to 1 $\mu$m, preferably 2 nm to 500 nm, and more preferably 5 nm to 200 nm.

<Electron injection layer>

The material constituting the electron injection layer may be appropriately selected based on the type of light-emitting layer. The electron injection layer may be a monolayer formed from Ca or Ba, for example. Alternatively, the electron injection layer may be formed from a laminate of a layer formed from one type or two or more types of, among Group IA and IIA metals of the periodic table excluding Ca and Ba, a metal having a work function of 1.5 to 3.0 eV and an oxide, halide, or carbonate of such metal, and a layer formed from Ca or Ba. Examples of Group IA metals of the periodic table having a work function of 1.5 to 3.0 eV, or an oxide, halide, or carbonate thereof, include lithium, lithium fluoride, sodium oxide, lithium oxide, and lithium carbonate. Further, examples of Group IIA metals, or an oxide, halide, or carbonate thereof, excluding Ca and Ba and having a work function of 1.5 to 3.0 eV include strontium, magnesium oxide, magnesium fluoride, strontium fluoride, barium fluoride, strontium oxide, and magnesium carbonate. The electron injection layer may be formed by vapor deposition, sputtering, printing and the like. It is preferred that the electron injection layer has a thickness of about 1 nm to 1 $\mu$m.

The above-described organic EL device 1 may be used in a lighting device. Since this lighting device includes the organic EL device 1 which, as described above, has a high light extraction efficiency, a low power consumption, high luminance lighting device can be realized. Further, as described above, since depressions exhibiting a function similar to that of a concave lens are provided on the surface of the film 3, illumination with a broad angle of radiation can be realized.

Although examples of the present invention will now be described, the present invention is not limited to these examples.

EXAMPLES

(Example 1)

As the transparent substrate 7, a 30 mm x 30 mm glass substrate was used. Next, a 150 nm-thick conductor film formed from ITO was vapor-deposited on the surface of the substrate 7 by sputtering. Then, a protective film having a predetermined pattern shape was formed by applying a photoresist to the surface of this conductor film, exposing a predetermined region via a photomask, and cleaning the exposed surface. Etching was carried out, then rinsing with water and NMP (n-methylpyrrolidone) to form an anode 4 formed from an ITO film having a predetermined pattern shape. Next, to remove resist residue on the anode 4, an oxygen plasma treatment was carried out for 2 minutes at an energy of 30 W, and UV/O$_3$ cleaning was carried out for 20 minutes.

Next, two-stage filtration was carried out on a suspension of poly(3,4)ethylenedioxythiophene/polystyrene sulfonic acid (trade name: Baytron P CH8000, manufactured by Starck V-Tech) to obtain a solution for the hole injection layer 6. In the first stage of filtration, a 0.45 $\mu$m diameter filter was used, and in the second stage of filtration, a 0.2 $\mu$m diameter filter was used. Using the solution obtained by filtration, a thin film was produced by spin coating. Then, a 70 nm-thick hole injection layer 6 was formed by heat treating at 200°C for 15 minutes on a hot plate under an air atmosphere.

Next, a xylene solution having a 1.2 mass% concentration of Lumation WP1330 (manufactured by Sumation) was produced. Using the produced solution, a thin film was formed on the surface of the hole injection layer 6 by spin coating. Then, an 80 nm-thick light-emitting layer 2 was formed by heat treating at 130°C for 60 minutes on a hot plate under a nitrogen atmosphere.

Then, the substrate on which the light-emitting layer 2 was formed was introduced into a vacuum vapor deposition apparatus. Ba and Al were successively vapor-deposited to a thickness of 5 nm and 80 nm, respectively, to form the cathode 5. The vapor deposition of the metals was started once the degree of vacuum reached 1 x 10$^{-4}$ Pa or lower.

Next, to produce the film 3, first, a solution for the film 3 was produced. 6.32 g of polycarbonate was dissolved in 20.7 g of dichloromethane to produce a 23.4 wt.% solution. Then, Novec (manufactured by 3M), which is a fluorine-based surfactant, was mixed into this solution. The concentration of Novec was adjusted to 0.8 wt.% to obtain the solution for the film 3. In a constant-temperature, constant-humidity bath having a humidity of 85%, the obtained solution for the film 3 was cast onto a glass base so that the thickness of the formed film 3 would be about 150 $\mu$m. After leaving for 5 minutes in an atmosphere having a humidity of 85%, the film was dried by a nitrogen flow to obtain a 20 mm x 20 mm film 3 having uneven shapes on the surface.

Then, glycerin was applied as a pressure-sensitive adhesive to the second surface of the substrate 7. The produced film 3 was bonded thereon to produce the organic EL device 1. The refractive index of the substrate 7 was 1.50, the refractive index of the pressure-sensitive adhesive was 1.45, and the refractive index of the film 3 was 1.58. The average thickness of the film 3 was 230 $\mu$m.

(Example 2)

An organic EL device 1 was produced which was different only in the film 3 from the organic EL device 1 of Example 1. In Example 2, a commercially-available film 3 was used which exhibited a high haze value (82). Since this film 3 had an adhesive layer, the organic EL device 1 was produced by directly bonding the film 3 on the substrate 7, without using a pressure-sensitive adhesive and the like.

(Comparative Example 1)

An organic EL device 1 was produced which was different only in the film 3 from the organic EL device 1 of Example 1. The same solution as that of Example 1 was used for the solution for the film 3. In a constant-temperature, constant-humidity bath having a humidity of 50%, the solution for the film 3 was cast onto a glass base so that the thickness of the formed film 3 would be about 220 $\mu$m. After leaving for 5 minutes in an atmosphere having a humidity of 50%, the film was dried by a nitrogen flow to obtain a 20 mm x 20 mm film 3. The obtained film 3 was bonded on the substrate 7 in the same manner as in Example 1 using the same pressure-sensitive adhesive as in Example 1 to produce the organic EL device 1.

(Comparative Example 2)

An organic EL device 1 was produced which was different only in the film 3 from the organic EL device 1 of Example 1. The same solution as that of Example 1 was used for the solution for the film 3. In a constant-temperature, constant-humidity bath having a humidity of 85%, the solution for the film 3 was cast onto a glass base so that the thickness of the formed film 3 would be about 220 $\mu$m. After leaving for 5 minutes in an atmosphere having a humidity of 85%, the film was dried by a nitrogen flow to obtain a 20 mm x 20 mm film 3 having uneven shapes on the surface. The obtained film 3 was bonded on the substrate 7 in the same manner as in Example 1 using the same pressure-sensitive adhesive as in Example 1 to produce the organic EL device 1.

(Comparative Example 3)

An organic EL device 1 was produced which was different only in the film 3 from the organic EL device 1 of Example 1. The same solution as that of Example 1 was used for the solution for the film 3. In a constant-temperature, constant-humidity bath having a humidity of 85%, the solution for the film 3 was cast onto a glass base so that the thickness of the formed film 3 would be about 360 $\mu$m. After leaving for 5 minutes in an atmosphere having a humidity of 85%, the film was dried by a nitrogen flow to obtain a 20 mm x 20 mm film 3 having uneven shapes on the surface. The obtained film 3 was bonded on the substrate 7 in the same manner as in Example 1 using the same pressure-sensitive adhesive as in Example 1 to produce the organic EL device 1.

(Film 3 Surface Observation)

The surface of the films used in Examples 1 and 2 and in Comparative Examples 1, 2, and 3 was observed by a scanning electron microscope (SEM). Fig. 2 is a diagram schematically illustrating a cross-section of the film 3 produced in Example 1. Fig. 3 is a diagram schematically illustrating a cross-section of the film 3 used in Example 2. Fig. 4 is a diagram schematically illustrating a cross-section of the film 3 produced in Comparative Example 1.

For the film 3 produced in Example 1, it was confirmed that hemispherical concavities having an average diameter of 2 $\mu$m were formed on the surface of the film 3. The concavities were confirmed to be formed over the whole surface of the film 3.

For the film 3 used in Example 2, it was confirmed that the surface of the film 3 was formed in an uneven shape. The concavities were confirmed to be formed over the whole surface of the film 3.

For the film 3 produced in Comparative Example 1, it was confirmed that concavities were not formed on the surface, and that the surface was flat.

For the film produced in Comparative Example 2, it was confirmed that hemispherical concavities having an average diameter of 3 $\mu$m were formed on the surface of the film 3. Although the regularity of the arrangement of the concavities was relatively low, the concavities were confirmed to be formed over the whole surface of the film 3.

For the film produced in Comparative Example 3, it was confirmed that hemispherical concavities having an average diameter of 4 $\mu$m were formed on the surface of the film 3. Although the regularity of the arrangement of the concavities was relatively low, the concavities were confirmed to be formed over the whole surface of the film 3.

Table 1 shows the humidity when the film 3 was produced in Example 1 and Comparative Examples 1, 2 and 3, and the properties of the film 3 used in Examples 1 and 2 and Comparative Examples 1, 2, and 3.

[Table 1]

Table 1

| | Humidity | Minimum thickness ($\mu$m) | Maximum thickness ($\mu$m) | Concavity diameter ($\mu$m) | Total light transmittance | Haze value |
|---|---|---|---|---|---|---|
| Example 1 | 85% | 130 | 170 | 2$\mu$m | 100 | 74 |
| Example 2 | - | 5 | 5 | - | 100 | 82 |
| Comparative Example 1 | 50% | 200 | 240 | None | 90 | 6 |
| Comparative Example 2 | 85% | 200 | 240 | 3$\mu$m | 98 | 62 |
| Comparative Example 3 | 85% | 340 | 380 | 5$\mu$m | 98 | 44 |

As illustrated in Table 1, it was confirmed that a film 3 having a high haze value can be produced by controlling humidity and the thickness of the produced film 3. Further, it was confirmed that if the thickness of the produced film 3 increases, concavity diameter increases.

(Organic EL Device 1 Light Extraction Efficiency)

The light intensity of the organic EL devices 1 which were produced in Examples 1 and 2 and in Comparative Examples 1, 2, and 3 with a film 3 bonded thereon and the light intensity of an organic EL device on which a film was not bonded were compared. Table 2 shows the light extraction efficiency obtained by dividing the light intensity of the organic EL devices 1 on which a film 3 was bonded by the light intensity of an organic EL device on which a film was not bonded. The light intensity was determined by flowing a 0.15 mA current through the organic EL deices, measuring the angular dependence of the emission intensity at that time, and integrating the emission intensity at all of the angles.

[Table 2]

Table 2

| | Light extraction efficiency ratio |
|---|---|
| Example 1 | 1.5 |
| Example 2 | 1.4 |
| Comparative Example 1 | 1.0 |
| Comparative Example 2 | 1.1 |
| Comparative Example 3 | 1.1 |

The organic EL device 1 of Example 1 showed a 1.5-fold increase in light extraction efficiency compared with prior to the film 3 being bonded. Further, similar to the organic EL device 1 of Example 1, the organic EL device 1 of Example 2, in which a film 3 was bonded having optical properties close to those of the film 3 in Example 1, also showed a large increase in light extraction efficiency. However, since the film 3 used in the organic EL device 1 of Comparative Example 1 had almost no light scattering, no increase in light extraction efficiency was seen. Further, no large improvement in light extraction efficiency was seen for Comparative Examples 2 or 3 either. Based on these results, it is clear that a film 3 having a high total light transmittance and a high haze value contributes to improved light extraction efficiency. Especially, it was learned that if the haze value of the film 3 is 70 or more, the light extraction efficiency improves substantially. Thus, it was confirmed that light extraction efficiency is improved by providing a film 3 which exhibits predetermined optical properties.

INDUSTRIAL APPLICABILITY

According to the present invention, an organic EL device having a high light extraction efficiency can be realized. Further, according to the present invention, a film having intended optical properties can be easily manufactured by a simple control.
In addition, according to the present invention, since a film having intended optical properties can be easily produced by a simple control, an organic EL device having a high light extraction efficiency can be easily manufactured.

**Claims**

1.  An organic electroluminescent device comprising a light-emitting layer which comprises an organic material and a film which is arranged facing the light-emitting layer and which is located on a surface portion, wherein
    the film has an uneven surface on the opposite side to the light-emitting layer side, a haze value of 70% or more and a total light transmittance of 80% or more.

2.  The organic electroluminescent device according to claim 1, wherein a surface of the film located opposite to the light-emitting layer is provided with a plurality of concavities and is unevenly formed.

3.  A lighting device comprising the organic electroluminescent device according to claim 1 or 2.

4.  A method for manufacturing a film which is platy in shape and uneven on one surface and has a haze value of 70% or more and a total light transmittance of 80% or more, the method comprising:

    an application step comprising applying a solution comprising a material for constituting the film to a surface of a base on which the film is to be formed so that the film may have a thickness in a range of 100 $\mu$m to 200 $\mu$m; and a film formation step comprising forming a film by holding the solution applied to the surface of the base at a humidity in a range of 80% to 90%, and then drying.

5.  A method for manufacturing an organic electroluminescent device comprising a light-emitting layer which comprises an organic material and a film which is arranged facing the light-emitting layer and which is located on a surface portion, the method comprising the steps of:

    forming a light-emitting layer which comprises an organic material; and
    providing on the surface portion a film produced by the method according to claim 4.

## FIG.1

## FIG.2

## FIG.3

## FIG.4

## INTERNATIONAL SEARCH REPORT

| | International application No. |
|---|---|
| | PCT/JP2009/055778 |

A. CLASSIFICATION OF SUBJECT MATTER
*H05B33/02*(2006.01)i, *G02B5/02*(2006.01)i, *H01L51/50*(2006.01)i, *H05B33/10* (2006.01)i

According to International Patent Classification (IPC) or to both national classification and IPC

B. FIELDS SEARCHED

Minimum documentation searched (classification system followed by classification symbols)
H05B33/02, G02B5/02, H01L51/50, H05B33/10

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2000-323272 A (Casio Computer Co., Ltd.), 24 November, 2000 (24.11.00), Claim 3; Par. Nos. [0030], [0042], [0056] (Family: none) | 1-5 |
| Y | JP 2007-188708 A (Dainippon Printing Co., Ltd.), 26 July, 2007 (26.07.07), Par. Nos. [0021], [0045], [0088] to [0090] (Family: none) | 1-5 |
| Y | JP 2004-335183 A (Nitto Denko Corp.), 25 November, 2004 (25.11.04), Claim 5; Par. Nos. [0001], [0027], [0059] to [0060] (Family: none) | 1-5 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 April, 2009 (14.04.09) | 21 April, 2009 (21.04.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

15

**INTERNATIONAL SEARCH REPORT**

| International application No. |
|---|
| PCT/JP2009/055778 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2004-325469 A  (Seiko Epson Corp.),<br>18 November, 2004 (18.11.04),<br>Par. Nos. [0005] to [0019]; Fig. 1<br>(Family: none) | 2,4-5 |
| P,X | JP 2009-32463 A  (Nippon Zeon Co., Ltd.),<br>12 February, 2009 (12.02.09),<br>Par. Nos. [0014] to [0070], [0103]<br>(Family: none) | 1,3 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007035550 A

**Non-patent literature cited in the description**

- **G Widawski ; M. Rawiso ; B. Francois.** *Nature,* 1994, 369-387